# EUROPEAN PATENT APPLICATION

(11) **EP 2 093 798 A2**
(43) Date of publication of application: **26.08.2009**
(21) Application number: 09151145.1
(22) Date of filing: 22.01.2009
(51) Int. Cl.: H01L 25/16, H01L 23/498

(54) **MCM Packages**

(30) Priority: 22.01.2008 US 9805
(71) Applicant: Sychip Inc., Plano, Texas 75093 (US)
(72) Inventor: Degani, Yinon, Highland Park, NJ 08904 (US); Fan, Yu, Plano, TX 75024 (US); Gao, Charley Chunlei, Plano, TX 75024 (US); Sun, Kunquan, Plano, TX 75093 (US); Sun, Liquo, Plano, TX 75093 (US)
(74) Representative: Williams, David John

(57) **Abstract**

An RF/IPD package with improved thermal management is described. The IPD substrate is attached to a system substrate with a thin RF chip mounted in the standoff between the IPD substrate and the system substrate. RF interconnections are made between the top of the RF chip and the bottom of the IPD substrate. Heat sinking is provided by bonding a heat sink layer on the RF chip to a heat sink layer on the system substrate. The heat sink may also serve as a ground plane connection. Combinations of other types of integrated devices may be fabricated using this approach.

## Description

### Field of the Invention

This invention relates to multi-chip module (MCM) integrated circuit packages and more specifically to Integrated Passive Device (IPD) packages with improved thermal control.

### Background of the Invention

Industry efforts to reduce the size of MCM packages continue to yield progress. With lithography design rules still shrinking impressively, the reduction in IC chip area has been dramatically reduced. Comparable results in reducing the thickness of MCM packages have been more difficult to attain.

IPD packaging in general presents a special case. Size reductions in IPD/RF packaging technology have lagged a step behind IC MCM packaging. This is partly due to the inherently larger size of IPD substrates. IPD packaging is also influenced by the presence of analog components in the RF and IPD subassemblies, and the need to account for stray electromagnetic effects. Thus stacking IPDs with other circuit elements as commonly done in transistor IC MCM packages has been constrained.

MCM integrated circuit packages containing RF chips are described, for example, in United States Patent No. 5,869,894. The MCM configuration described there demonstrates one aspect of the limitations on thickness of MCM packages. The RF chip is located in the stand-off between a relatively larger IC host chip, for example a memory of logic chip, and a substrate. The RF chip is bonded to the host chip, and the pair is flip-chip bonded to the substrate. This arrangement allows the ground plane of the RF chip to be conveniently interconnected directly to a ground plane on the substrate. To provide the required stand-off, an intermediate interconnect substrate is used.

However, this package overall is still relatively large by current standards. Further reductions in package thickness would be desirable.

Special problems are encountered when the RF chip that is being stacked in a stacked MCM is, for example, an RF power amplifier chip. These chips generate a large amount of heat, and inserting them in a confined space raises issues of thermal management.

### Statement of the Invention

An improved RF/IPD package has been developed with significantly reduced thickness, and with improved thermal management. An embodiment of improved package is described in general as follows. The IPD substrate is attached to a system substrate. A very thin RF chip is mounted in the standoff between the IPD substrate and the system substrate, RF interconnections are made between the top of the RF chip and the bottom of the IPD substrate. The very thin RF chip requires unconventional means for heat dissipation. According to the invention, a heat sink is provided between the RF chip and the system substrate. The heat sink may also serve as a ground plane connection. The combination of a very thin RF chip specially mounted on an IPD represents a subassembly according to the invention. In the preferred embodiment the subassembly is an RF/IPD combination. However, RF/IC, IC/IPD, or IC/IC combinations may be produced according to these teachings.

### Brief Description of the Drawing

Fig. 1 is a schematic representation of a stacked MCM in a conventional arrangement;
Fig. 2 is a view similar to that of Fig. 1 but illustrating the technical advance of the invention; and
Figs. 3-9 schematically show typical steps in the fabrication of a subassembly according to one aspect of the invention;
Figs. 10-13 represent steps for preparing a system substrate and assembling a completed RF/IPD package using the subassembly of Fig. 9.

### Detailed Description

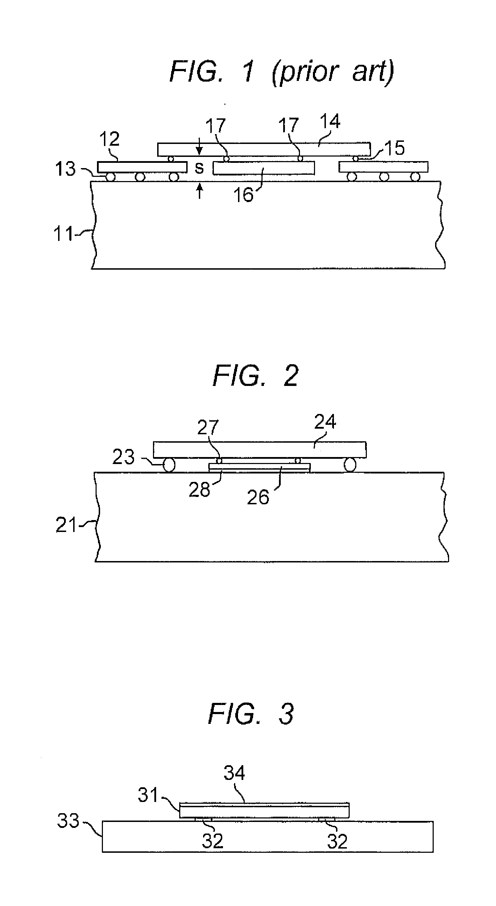

Referring to Fig. 1, a conventional stacked MCM is shown comprising substrate 11, with intermediate interconnect substrate (IIS) 12 bonded to the substrate with solder bumps 13. A first MCM IC chip 14 is mounted on top of the IIS and attached with solder bumps 15. A second MCM IC chip 16 is shown occupying the space between the first MCM IC chip 14 and the substrate 11. The space between the bottom of the IC chip and the substrate 11 is referred to as the standoff space and has height s in the figure.

The height of the standoff space is important. Sufficient height is required to accommodate an IC chip in the space. In the arrangement of Fig. 1, the standoff space is created by the IIS 12. Typical stacked MCM packages where an IC component is mounted in a standoff space will have one or more IIS elements to create the standoff.

As device dimensions shrink, the standoff space is reduced. This makes even more essential the role of one or more IIS elements to provide adequate standoff for packages that utilize the standoff space for mounting additional IC elements.

Fig. 2 shows an RF/IPD package according to a preferred embodiment of the invention. As suggested earlier, the preferred embodiment comprises an RF/IPD combination, and that combination will be used as an example of the broader categories of IPD/IC and IC/IC. In this context the term "integrated device" is used to encompass both IC devices and IPD devices.

An IPD device 24 is shown attached directly to system substrate 21 with solder bumps 23. The IPD device substrate may be laminate, ceramic, silicon, or other appropriate material. The substrate 21 may be a single or multi-level interconnection substrate, for example, a single or multi-level printed wiring board. A cutaway portion of the substrate is shown in the figure to illustrate that the substrate may be a system board, and may be considerably larger than the IPD device to accommodate several IPD and IC devices.

RF IC chip 26 is attached to the IPD device 24 with solder bumps 27. While the figures in the drawing are not to scale, it should be appreciated that the standoff space in the arrangement of Fig. 2 is small, too small to accommodate an additional chip in a conventional arrangement. This is due largely to the omission of an IIS. To fit the IC chip in the standoff space the IC chip 26 is very thin. However, it still does not fit in the standoff in the manner shown in Fig. 1, where the standoff space S provides a gap between the RF IC chip 16 and the substrate 11. Instead of providing a gap between RF chip 26 and the substrate, the IC chip is attached to the substrate via solder attachment 28. In this embodiment the IC chip 26 is an RF power chip, for example, a power amplifier, which generates significant amounts of both electromagnetic noise and heat. In the arrangement shown, the solder attachment 28 functions as a heat sink for RF IC chip 26. It also connects the RF chip to a ground plane on the substrate.

In flip chip arrangements like that described here, it is conventional to fill the gap between the chips and the system substrate with epoxy underfill, mainly for promoting the physical integrity of the package. However, in the arrangement shown in Fig. 2 the heat sink 28 provides the equivalent of an underfill function and additional underfill may not be required. However, in many cases an additional underfill may be desirable for overall structural integrity.

It is evident from the above that the IPD substrate should be significantly larger than the RF IC chip to provide space for the direct interconnections between the IPD substrate and the system substrate.

Figs. 3-6 illustrate a fabrication sequence for a stacked RF/IPD package similar to that of Fig. 2. In this sequence, a preferred embodiment, a flip-chip assembly technique is used. The stacked RF chip/IPD subassembly, and the substrate, are prepared separately, then the stacked RF/IPD subassembly is flip-chip bonded to the substrate. Other suitable options may be used. Fig. 3 shows IPD device 33 with RF power chip 31 attached to the surface of the IPD device with solder attachments 32. Both of the components 31 and 33 are typically provided with bond pads and under bump metallization. Under bump metallization (UBM) is well known. It provides a robust, wettable, corrosion free, interface for solder interconnections. For simplicity in this description the bond pads and the UBM are not shown. However, it should be understood that the solder attachments described herein are provided with the conventional means necessary for reliable solder attachments.

A heat sink layer 34 is applied to the backside of the RF chip as shown. In suitable cases the heat sink layer may also serve as a metallization layer for flip-chip bonding. As will be apparent to those skilled in the art, the heat sink metallization should be applied directly to the semiconductor and any oxide that has been grown or deposited, or native oxide formed during processing, should be removed prior to applying the heat sink layer. However, if the chip is not an RF chip, or if the heat sink metallization is not needed as a ground plane contact, other arrangements may be suitable. For example, in some cases the top layer of the chip It is preferred to apply the heat sink layer to the chip at the wafer stage, where it can be applied at any convenient point in the wafer fabrication sequence. The material used for the heat sink layer may be any appropriate thermally conductive material, e.g. Au, Au-Sn, Cr/CrCu/Cu, TiPdAu, Al, Ag-Sn, Ag-Sn-Cu, etc. A superior solder wettable metal such as TiPdAu may be preferred as it facilitates direct soldering to the heat sink layer on the substrate.

A typical thickness (height) for the IPD substrate is 100-350 microns, preferably less than 250 microns, or even less than 200 microns. The RF power chip 31 is typically 50-300 microns thick, preferably less than 100 microns and optimally less than 75 microns. IC chips with a thickness less than 100 microns can be produced using state of the art technology; in many cases IC chip thinning technology.

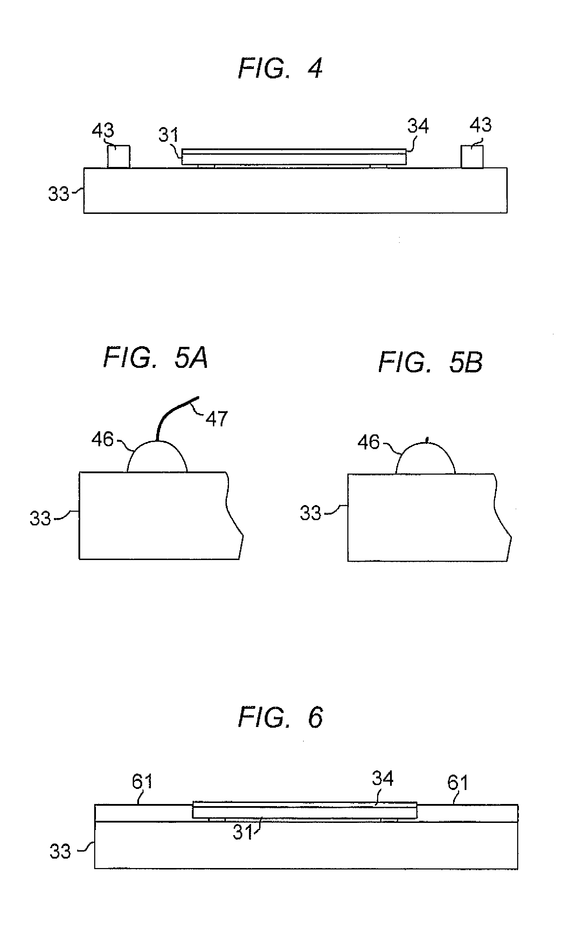

Fig. 4 shows the application of solder bumps 43 to bond pads (not shown) on the substrate. The solder is preferably a lead free alloy, for example Au-Sn or Ag-Sn. It is chosen for both thermal conductivity and high electrical conductivity. Gold, silver, and copper alloys are preferred. Solder bumps 43 may be described by the generic term bonding bodies, and the size of the bonding bodies largely determines the standoff between the bottom surface of the IPD substrate and the top surface of the system substrate. As mentioned above, the bonding bodies are formed over bond pads and UBM. To increase the standoff the thickness of the bond pads and/or the UBM under the bonding bodies may be enhanced. Conductive spacers may be added for the same purpose.

The bonding bodies may assume a variety of constructions. Solder has been mentioned above. Metal posts or columns may be used and these may be formed by any suitable method. Another alternative is shown in Figs. 5A and 5B. In Fig. 5A a gold wire bond is attached to the IPD surface. The IPD surface would normally carry a series of bond pads (not shown). In a typical wire bond the end of the gold wire is attached to one surface by arc welding. This results in the formation of a gold bump 46. The remaining gold wire is shown at 47, protruding from the gold bump 46. The other end is normally attached to another bond pad. However, the wire may be severed leaving the gold bump 46. Gold bumps that are produced in this manner may be used to attach the RF/IPD subassembly to a system board. The attachment method may be thermocompression bonding, or may employ gold alloy solder.

As indicated above, a wide variety of choices exist for the material and structure of the bond bodies. An especially useful step sequence is represented by Figs. 6-9. The general objective of this sequence is to produce a robust subassembly of an RF chip and an IPD. That subassembly may be manufactured and sold as a unit component to system integrators.

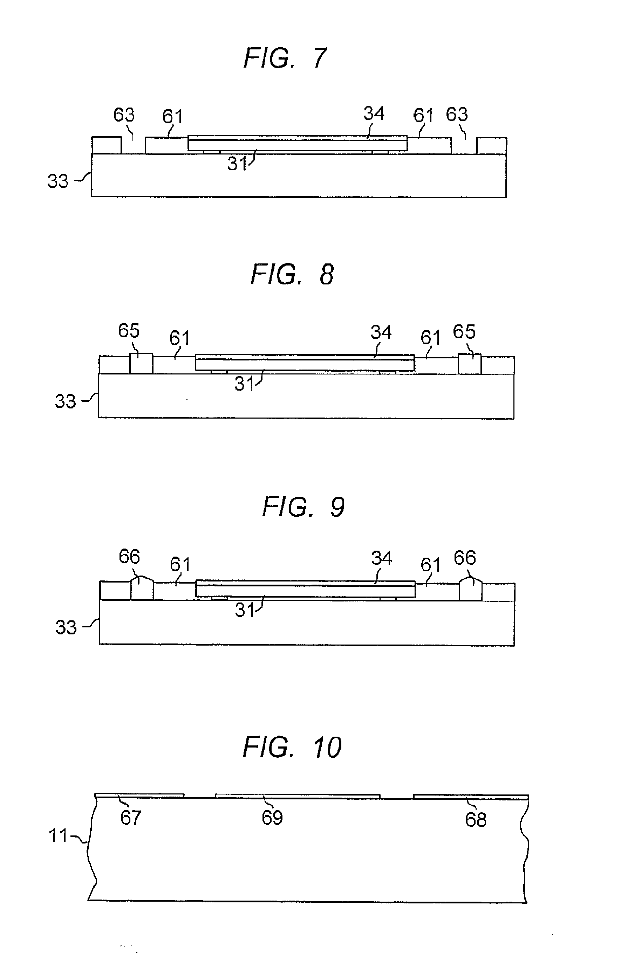

Fig. 6 shows the structure of Fig. 4 without the bonding bodies 43. The structure is coated with a polymer layer 61. This layer may serve as an underfill in the finished subassembly. The thickness of layer 61 is preferably chosen so that the surface of the heat sink layer 34 remains exposed. The material of layer 61 may be any suitable prepolymer material. It may be a photodefinable polymer, such as a photosensitive polyacrylate or photosensitive polyamide. It may be one of a variety of photoresists. Layer 61 may then be patterned by photodefinition to produce the structure shown in Fig. 7. In Fig. 7 sites for bonding bodies are shown at 63. Alternatively, if polymer layer 61 is not photodefined, openings 63 may be formed by laser drilling, by photoresist and etching, or by any suitable method. Fig. 8 shows the openings for the bonding bodies filled with solder paste 65. Fig. 9 shows the bonding bodies 66 after reflow,

Figs. 4-9 represent a preferred embodiment wherein the solder means attaching the IPD device 24 (Fig. 2) to substrate 21 are formed on the IPD subassembly. A variety of attachment approaches may be used for this attachment. Solder bumps may be provided on the substrate. Or solder may be applied to both the substrate and the IPD subassembly. A preferred approach is that described above, wherein solder bumps are provided on the IPD subassembly, combined with the application of solder paste to the substrate in preparation for final assembly. The latter is shown in Figs. 10-13.

Fig. 10 shows the substrate prior to flip-chip bonding. Conductive runners 67 and 68 form interconnections for the IPD. Pad 69 represents a heat sink layer on substrate 11. The heat sink layer may also function as part of the electrical circuitry, for example, a ground plane connection for the common ground of the system board. It is preferable to locate the heat sink layer 69 on the same level as bond pads 67 and 68, but alternative arrangements may also be effective. Locating these elements on the same level facilitates the flip-chip bonding arrangement shown, wherein the bond between the heat sink layer on the RF chip and the heat sink layer on the system substrate is made at the same time the IPD substrate is electrically connected to the system board.

The heat sink layer 69 is preferably approximately coextensive with the RF chip footprint as shown to provide an effective heat sink. Where the heat sink layer serves as a ground plane interconnection it may connect with other circuitry via a surface runner, or may be connected through an interlevel plug to a ground plane at a lower level in a multi-level interconnect substrate.

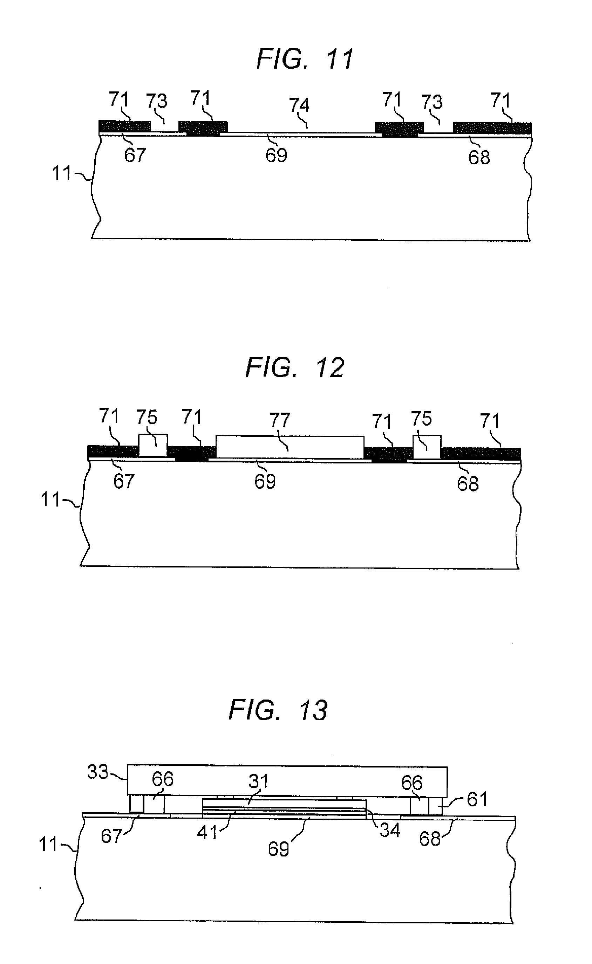

One embodiment showing preparation of a system substrate for assembly of the RF/IPD subassembly to the system substrate is illustrated in Figs. 11 and 12. Fig. 11 shows a soldermask layer 71 covering the surface of the illustrated portion of the system substrate except for the IPD interconnection sites 73, and the heat sink attachment site 74. Fig. 12 shows solder paste 75 applied to the surface of the substrate including the IPD interconnection sites 75 and the heat sink attachment site 77. At this stage the RP/IPD subassembly of Fig.9 may be flip-chip placed on the system substrate of Fig. 12 and the solder reflowed to effect the attachment.

The resulting assembly is shown in Fig. 13. Fig. 13 shows the stacked RF/IPD subassembly flip-chip bonded to system substrate 11. The heat sink layer 34 on the RF chip 31 is bonded to heat sink layer 69 on substrate 11 for heat sinking. While the assembly shown in Fig. 13 has the advantage of prefabricated underfill, additional underfill may be provided if desired.

The technique used for the flip chip bond and the constitution of the bonds is described above as an example of many options. Alternatively the bonds may comprise a simple array of large solder bumps, or balls. Conductive epoxy, etc. may also be substituted for one or more of the bonds. The bonds themselves may be referred to herein as bonding bodies, and in the embodiments described here the bonding bodies have a thickness that is approximately equal to the thickness of the RF IC chip (including the heat sink layer on the RF IC chip).

The figures illustrate a flip-chip fabrication sequence in which solder is applied to the RF/IPD chip assembly and the RF/IPD chip assembly is attached to the system substrate by reflowing the solder on the RF/IPD chip assembly. Alternatively, solder may be applied first to selected sites on the system substrate and the RF/IPD chip assembly attached to the system substrate by reflowing the solder on the system substrate.

As just mentioned, other assembly methods may be used. For example, since the RF chip is attached to the substrate in the final assembly, it may be attached to the substrate initially, rather than soldered initially to the IPD device as shown in Fig. 3. However, the step sequence described in detail above is the preferred embodiment of the invention. As indicated, it results in an intermediate product that is itself a viable commercial product. One advantage of this assembly sequence is that the assembled combination of RF chip and IPD can be fully tested prior to mounting on the system substrate. This is not the case for the sequence wherein the RF chip is attached first to the system substrate.

To implement the invention it is evident that when the IPD device is bonded to the system substrate, the dimensions, in particular the thickness, of the RF chip and the bonding layers should be such that the surface of the heat sink layer of RF chip is nearly in contact with the heat sink layer of the system board. Accordingly, to achieve that result, the height of the solder attachments (43 in Fig. 4) should be approximately the same as the thickness of the RF chip plus the thickness of the heat sink layer 34.

Also for the purpose of defining the invention, in particular a configuration in which the RF chip is interconnected to an IPD device, the RF chip has a circuit side where the IC is fabricated, and a heat sink side which, according to the invention, has a heat sink layer. When the RF chip is flip-chip bonded to the IPD device, the circuit side is bonded to the IPD device, and the surface of the heat sink layer is exposed. The IPD device is also bonded "upside down" to the system substrate so that when the IPD device is attached to the system substrate the exposed heat sink layer surface of the RF chip is adjacent the heat sink layer on the system substrate to allow direct bonding between them.

In the preferred embodiment described the IC device mounted in the standoff space is an RF power IC chip and the substrate to which the RF chip is attached is an IPD substrate. Alternatively, the large substrate may be a semiconductor IC chip, for example, a semiconductor memory or logic chip. Combinations of these IC chips with other IC chips, particularly IC power chips, are potentially attractive. As mentioned earlier, all of these options are intended to be covered in a system wherein the large substrate is an integrated device substrate and the smaller device, mounted in the stand-off, is an IC chip.

Various additional modifications of this invention will occur to those skilled in the art. All deviations from the specific teachings of this specification that basically rely on the principles and their equivalents through which the art has been advanced are properly considered within the scope of the invention as described and claimed.

## Claims

1. An electronic package comprising:
a. a system substrate having an array of system substrate interconnection sites and a heat sink layer,
b. an integrated device substrate with:
i. a first array of integrated device interconnection sites adapted for interconnection to an IC chip,
ii. a second array of interconnection sites on the integrated device substrate on the same side of the integrated device substrate as the said first array of integrated device interconnection sites said second array of interconnection sites adapted for interconnection with said system substrate interconnection sites,
c. an IC chip comprising an IC circuit side of the chip and a heat sink side of the chip and having an array of IC chip interconnection sites on the IC circuit side of the IC chip and a heat sink layer on the heat sink side of the IC chip, said IC chip being flip-chip bonded to the integrated device substrate with the array of IC chip interconnection sites bonded to the first array of integrated device interconnection sites,
the invention **characterized in that** the integrated device substrate is attached directly to the system substrate, with the second array of interconnection sites bonded to the system substrate interconnection sites, and the heat sink layer on the IC chip and the heat sink layer on the system substrate bonded together.

2. The electronic package of claim 1 wherein the integrated device comprises an IPD substrate and the IC chip is an RF IC chip and the second array of IPD interconnection sites is bonded to the system substrate interconnections sites with bonds having thickness t₁.

3. The electronic package of claim 2 wherein the RF chip has thickness t₂, and t₂ is approximately equal to t₁.

4. The electronic package of claim 3 wherein t₂ is less than 100 microns and the thickness of the IPD substrate is less than 250 microns.

5. The electronic package of claim 2 wherein the IPD substrate is attached directly to the system substrate with bonding bodies selected from the group consisting of gold balls, lead-free solder, and conductive epoxy.

6. A method for fabricating an electronic package comprising the steps of:
a. flip-chip bonding an IC chip to an integrated device substrate,
b. bonding the integrated device substrate to a system substrate,
c. forming a heat sink between the IC chip and the system substrate.

7. The method of claim 6 wherein the integrated device comprises an IPD substrate and the IC chip is an RF IC chip.

8. The method of claim 7 wherein the IPD substrate is bonded to the system substrate with bonding bodies selected from the group consisting of gold balls, lead-free solder, and conductive epoxy, the bonding bodies having thickness t₁.

9. The method of claim 8 wherein the RF chip has thickness t₂, and t₁ and t₂ are approximately equal.

10. The method of claim 7 wherein the IPD substrate has a first side, with the RF chip bonded to the first side, and wherein the IDP substrate is bonded to the system substrate with bonds located on the first side.

11. The method of claim 10 including the steps of forming a first heat sink layer on the RF chip, forming a second heat sink layer on the system substrate, and bonding the first heat sink layer and the second heat sink layer together.

12. The method of claim 7 wherein the RF chip has a thickness of less than 100 microns.

13. Method for fabricating an RF/IPD package comprising the steps of:
a. forming a system substrate having an array of system substrate interconnection sites and a heat sink layer,
b. forming an integrated passive device (IPD) substrate having:
i. a first array of IPD interconnection sites adapted for interconnection to an RF chip,
ii. a second array of IPD interconnection sites on the IPD substrate on the same side of the interconnection substrate as the said first array of substrate interconnection sites said second array of IPD interconnection sites adapted for interconnection with said system substrate interconnection sites,
c. flip-chip bonding an RF chip to the IPD substrate, the RF chip having an RF circuit side of the chip and a heat sink side of the chip and having an array of RF chip interconnection sites on the RF circuit side of the RF chip and a heat sink layer on the heat sink side of the RF chip, the RF chip being flip-chip bonded to the IPD substrate with the array of RF chip interconnection sites bonded to the first array of IPD interconnection sites,
d. bonding the IPD substrate directly to the system substrate with the second array of IPD interconnection sites on the IPD substrate bonded to the array of system substrate interconnection sites, and
e. bonding the heat sink layer on the RF chip and the heat sink layer on the system substrate together.

14. An RF/IPD package subassembly comprising:
a. an IPD substrate with:
i. a first array of IPD interconnection sites adapted for interconnection to an RF chip,
ii. a second array of IPD interconnection sites on the IPD substrate on the same side of the interconnection substrate as the said first array of substrate interconnection sites said second array of IPD interconnection sites adapted for interconnection with a system substrate,
iii. an array of bonding bodies attached to the second array of IPD interconnection sites, the array of bonding bodies have a thickness t₁,
b. an RF chip with a thickness t₂ where t₁ and t₂ are approximately equal, the RF chip comprising an RF circuit side of the chip and a heat sink side of the chip and having an array of RF chip interconnection sites on the RF circuit side of the RF chip and a heat sink layer on the heat sink side of the RF chip, said RF chip being flip-chip bonded to the IPD substrate with the array of RF chip interconnection sites bonded to the first array of IPD interconnection sites.

15. Method for fabricating an RF/IPD package subassembly comprising the steps of:
a. forming an integrated passive device (IPD) substrate having:
i. a first array of IPD interconnection sites adapted for interconnection to an RF chip,
ii. a second array of IPD interconnection sites on the IPD substrate on the same side of the interconnection substrate as the said first array of substrate interconnection sites said second array of IPD interconnection sites adapted for interconnection with a system substrate,
iii. an array of bonding bodies attached to the second array of IPD interconnection sites, the array of bonding bodies have a thickness tᵢ,
b. flip-chip bonding an RF chip to the IPD substrate, the RF chip having a thickness t₂, where t₁ and t₂ are approximately equal, the RF chip having a circuit side of the chip and a heat sink side of the chip and having an array of RF chip interconnection sites on the RF circuit side of the RF chip and a heat sink layer on the heat sink side of the RF chip, the RF chip being flip-chip bonded to the IPD substrate with the array of RF chip interconnection sites bonded to the first array of IPD interconnection sites,

16. The method of claim 15 wherein the IPD substrate is formed by performing steps a.i, a.ii, and b., and thereafter performing step a.iii, and step a.iii is performed by:
c. applying a polymer layer over the IPD substrate with a thickness that exposes the surface of the RF chip,
d. forming openings in the polymer layer, and
e. performing step a.iii. in the openings.
